# EUROPEAN PATENT SPECIFICATION

(11) **EP 0 927 509 B1**
(45) Date of publication and mention of the grant of the patent: **08.09.2004**
(21) Application number: 98925509.6
(22) Date of filing: 30.04.1998
(51) Int. Cl.: H05K 7/00

(54) **MOUNTING BRACKET PARTICULARLY FOR ELECTRICAL DEVICES**
HALTEVORRICHTUNG FÜR ELEKTRISCHE VORRICHTUNG
SUPPORT DE FIXATION PARTICULIEREMENT CONCU POUR DES DISPOSITIFS ELECTRIQUES

(30) Priority: 20.05.1997 IT MI970355 U
(43) Date of publication of application: 07.07.1999
(73) Proprietor: GEWISS S.p.A., I-24069 Cenate Sotto (Bergamo) (IT)
(72) Inventor: BOSATELLI, Domenico, I-24069 Cenate Sotto (IT); CONTARDI, Augusto, I-21100 Varese (IT); PIANEZZOLA, Sergio, I-21100 Calcinate del Pesce (IT)
(74) Representative: Forattini, Amelia
(86) International application number: PCT/EP1998/002560
(87) International publication number: WO 1998/053653

(56) References cited:
- FR-A1- 2 646 568
- US-A- 4 035 052
- US-A- 4 087 669
- US-A- 4 098 423
- US-A- 4 435 739
- US-A- 5 393 942

## Description

The present invention relates to a mounting bracket particularly for electrical devices.

Electrical devices such as modular automatic breakers or the like include a fastening means for a removable coupling to omega-shaped guides according to DIN standards. The fastening means generally includes hooks which are retained in closed position on the guide by means of a spring.

A drawback of conventional fastening means is that, in order to be able to disengage the module from the guide, it is necessary to act on the hooks by retaining them, for example by means of a screwdriver, in the open position, overcoming the force of the spring.

If more than one module is to be unfastened from the guide, as generally occurs, it is rather difficult to act on the two hooks of each module in order to extract the chosen module.

The aim of the present invention is to provide a mounting bracket which greatly facilitates the installation and optional removal of electrical devices.

An object of the invention is to provide a mounting bracket which complies to standards.

A further object of the invention is to provide a mounting bracket which is constructively simple and cheap from the point of view of production.

This aim, these objects and others which will become apparent hereinafter are achieved by a mounting bracket particularly for electrical devices, including a block which is rigidly coupled to an electrical device to be mounted on a support and a slider which can move in a seat formed in the block, characterized in that the slider has a bistable elastic means which is suitable to stably retain the slider in at least two stable positions: namely, an open position and a closed position in which the slider can engage a guide of the support.

Further characteristics and advantages will become apparent from the description of the mounting bracket particularly for electrical devices, illustrated only by way of non-limitative example in the accompanying drawings, wherein:
Fig. 1 is a schematic and partially sectional lateral elevation view of a breaker provided with mounting brackets according to the invention, shown in the open position;
Fig. 2 is a view, similar to Fig. 1, but with the brackets in closed position;
Fig. 3 is a partially sectional rear view, in which the brackets are in the open position;
Fig. 4 is a view, similar to Fig. 3, but with the brackets in closed position;
Fig. 5 is a perspective view of the slider of the bracket according to the invention.

An electrical device, for example a breaker 3, is described by way of example with reference to the above figures; the breaker includes a pair of mounting brackets, each of which is generally designated by the reference numeral 1, and is constituted by a slider 5 which can move in a block 7 which is rigidly coupled to the device 3. The blocks 7 are arranged at the upper and lower ends of the rear side of the device so as to surround an omega-shaped rail or guide according to DIN standards (not shown in the figures), on which the device is to be mounted.

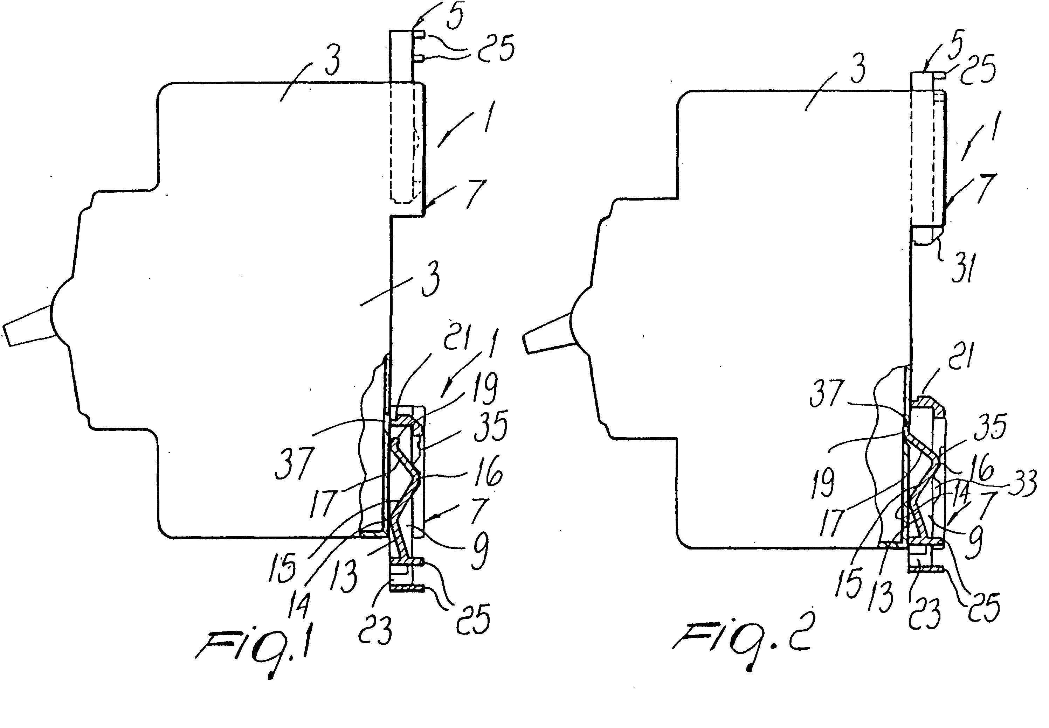

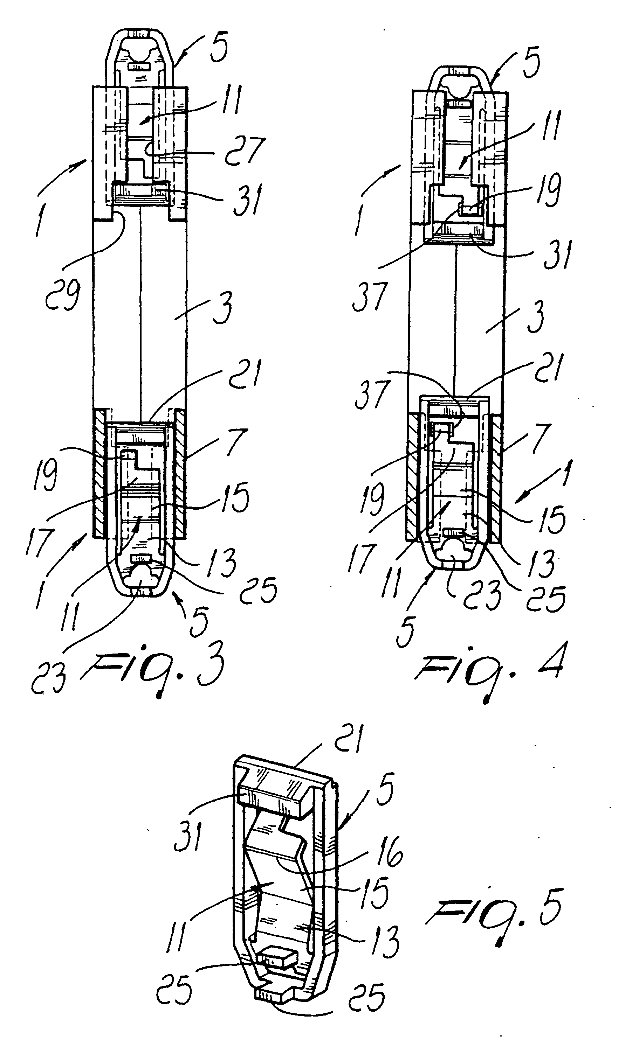

Each block 7 includes a substantially vertical seat which is open at the top and at the bottom and is suitable to slidingly accommodate the movable slider 5. The slider 5 includes a bistable elastic means 11 which is suitable to keep the slider 5 in at least two stable positions: an open position, shown in Figs. 1 and 3, and a closed position, shown in Figs. 2 and 4.

The bistable elastic means is conveniently constituted by a blade, preferably formed monolithically in the plastic slider, which has three mutually angled portions: respectively, a first portion 13, a second portion 15 and a third portion 17 which is provided with a tab 19 which is in turn slightly angled with respect to the third portion 17. The first portion 13 and the second portion 15 are mutually connected by a first rounded edge 14; the second portion 15 and the third portion 17 are connected by a second rounded edge 16. The slider 5 also includes a hook member 21 which is suitable to interact with the guide or rail to which the electrical device 3 will be applied. A central insert 31 is provided at the hook member 21. At the opposite end with respect to the hook member 21, the slider has a mounting and grip means which is constituted by a hole 23 which is arranged between two inserts 25 which are directed toward the wall to which the electrical device 3 will be fastened.

The seat 9 of the block 7, which is suitable to receive the slider 5, includes for this purpose a first open slot 27 which leads into a second open slot 29 which is wider than the first slot and is suitable to receive the central insert 31 of the slider 5. The seat 9 has a first angular closed slot 33, which is suitable to engage the second rounded edge 16 of the slider in the open position (Fig. 1), and a second closed slot 35, which is suitable to engage the second rounded edge 16 of the slider in the closed position (Fig. 2).

The seat 9 includes a third slot or recess 37 which is suitable to engage the tab 19 of the slider in the closed position (Figs. 2 and 4).

The operation of the bracket according to the invention is very simple. The slider 5, as mentioned, has two positions: an open one and a closed one. In order to apply the module 3 to the guide, it is sufficient to arrange the sliders 5 in the open position (Figs. 1 and 3), rest the module 3 against the guide (not shown in the figures) and close the sliders, moving them by acting on the outer ends (at the holes 23). It is also possible to apply the module to the rail with the sliders in closed position, since the rounding of the hook member 21 allows the slider to retract, overcoming the elastic force of the blade and achieving snap insertion of the module on the rail. Furthermore, when the module is applied to the rail, the slider is advantageously forced slightly on the rail due to the elastic force applied by the blade, so as to prevent sliding of the module along the rail, which is advantageous in vertically arranged rails.

The holes 23 are used subsequently to optionally remove the module, allowing the insertion of a screwdriver, for example, in order to move the sliders into the open position.

It is noted that the presence of the inserts 25 and of the hole 23 allows to use the sliders in the open position in order to fix, optionally by virtue of screws, the module 3 to the wall without the aid of the omega-shaped guides.

In practice it has been found that the invention achieves the intended aim and objects.

The materials used, as well as the dimensions, may be any according to the requirements and the state of the art.

Where technical features mentioned in any claim are followed by reference signs, those reference signs have been included for the sole purpose of increasing the intelligibility of the claims and accordingly, such reference signs do not have any limiting effect on the scope of each element identified by way of example by such reference signs.

## Claims

1. Mounting bracket particularly for electrical devices, comprising a block (7) which is rigidly coupled to an electrical device (3) to be mounted on a support and a slider (5) which can move in a seat (9) formed in said block; **characterized in that** said slider (5) has a bistable elastic means (11) which is suitable to stably retain said slider in at least two stable positions: namely, an open position and a closed position in which said slider can engage a guide of said support.

2. Bracket according to claim 1, **characterized in that** said bistable elastic means is constituted by a blade (11) which has three mutually angled portions: respectively, a first portion (13), a second portion (15) and a third portion (17) which has a tab (19) which in turn is slightly angled with respect to the third portion; said first portion and said second portion being connected by a first rounded edge (14); said second portion and said third portion being connected by a second rounded edge (16).

3. Bracket according to claim 1 or 2, **characterized in that** said seat (9) of the block, which is suitable to receive the slider (5), comprises a first open slot (27) which leads into a second open slot (29) which is wider than the first slot and is suitable to receive a central insert (31) of the slider (5); said seat having a first closed angular slot (33) which is suitable to engage the second rounded edge (16) of the slider, in the open position, and a second closed slot (35) which is suitable to engage the second rounded edge (16) of the slider in the closed position; said seat comprising a third slot (37) which is suitable to engage the tab (19) of the slider in the closed position.

4. Bracket according to one or more of the preceding claims, **characterized in that** said slider (5) has a mounting and grip means which is constituted by a hole (23) which is arranged between inserts (25) which are directed toward the support to which the electrical device will be fastened; said hole being suitable to receive a tool for the actuation of said slider or a screw member or the like in order to fasten said device to said support.

## Patentansprüche

1. Halterung insbesondere für elektrische Vorrichtungen, umfassend einen Block (7), welcher starr mit einer elektrischen Vorrichtung (3) verbunden ist, die auf einem Träger anzubringen ist, und einen Schieber (5), welcher sich in einer Aufnahme (9) bewegen kann, die in dem Block ausgebildet ist, **dadurch gekennzeichnet, dass** der Schieber (5) ein bistabiles elastisches Element (11) aufweist, welches geeignet ist, den Schieber in wenigstens zwei stabilen Positionen stabil zu halten: nämlich einer offenen Position und einer geschlossenen Position, in welcher der Schieber in eine Führung des Trägers eingreifen kann.

2. Halterung nach Anspruch 1, **dadurch gekennzeichnet, dass** das bistabile elastische Mittel durch ein Blatt (11) gebildet wird, welches drei zueinander abgewinkelte Abschnitte aufweist: einen ersten Abschnitt (13), einen zweiten Abschnitt (15) beziehungsweise einen dritten Abschnitt (17), welcher eine Lasche (19) aufweist, welche ihrerseits in Bezug auf den dritten Abschnitt leicht abgewinkelt ist; wobei der erste Abschnitt und der zweite Abschnitt durch eine erste abgerundete Kante (14) verbunden sind und der zweite Abschnitt und der dritte Abschnitt durch eine zweite abgerundete Kante (16) verbunden sind.

3. Halterung nach Anspruch 1 oder 2, **dadurch gekennzeichnet, dass** die Aufnahme (9) des Blocks, welche geeignet ist, den Schieber (5) aufzunehmen, einen ersten offenen Schlitz (27) umfasst, welcher in einen zweiten offenen Schlitz (29) führt, welcher breiter als der erste Schlitz ist und sich eignet, einen zentralen Einssatz (31) des Schiebers (5) aufzunehmen; wobei die Aufnahme einen ersten geschlossenen ringförmigen Schlitz (33), welcher geeignet ist, in der offenen Position die zweite abgerundete Kante (16) des Schiebers zu erfassen und einen zweiten geschlossenen Schlitz (35), welcher geeignet ist, in der geschlossenen Position die zweite abgerundete Kante (16) des Schiebers zu erfassen, aufweist; und die Aufnahme einen dritten Schlitz (37) umfasst, welcher geeignet ist, in der geschlossenen Position die Lasche (19) des Schiebers zu erfassen.

4. Halterung nach einem oder mehreren der vorhergehenden Ansprüche, **dadurch gekennzeichnet, dass** der Schieber (5) ein Befestigungs- und Greifmittel aufweist, welches durch ein Loch (23) gebildet wird, welches zwischen Einsätzen (25) angeordnet ist, welche zum Träger gerichtet sind, an welchem die elektrische Vorrichtung befestigt wird; wobei das Loch geeignet ist, ein Werkzeug zur Betätigung des Schiebers oder ein Schraubenelement oder dergleichen aufzunehmen, um die Vorrichtung an dem Träger zu befestigen.

## Revendications

1. Support de montage, en particulier pour dispositifs électriques, comprenant un bloc (7) qui est accouplé rigidement à un dispositif électrique (3) qu'il s'agit de monter sur un support et un coulisseau (5) qui peut se déplacer dans un logement (9) formé dans ledit bloc, **caractérisé en ce que** ledit coulisseau (5) possède un élément élastique bistable (11) qui est approprié pour retenir ledit coulisseau de façon stable dans au moins deux positions stables : à savoir une position ouverte et une position fermée dans laquelle ledit coulisseau peut coopérer avec un guide dudit support.

2. Support selon la revendication 1, **caractérisé en ce que** ledit moyen élastique bistable est constitué par une lamelle (11) qui a trois portions coudées l'une par rapport à l'autre : respectivement, une première portion (13), une deuxième portion (15) et une troisième portion (17), laquelle présente une languette (19) qui est à son tour légèrement coudée par rapport à la troisième portion ; ladite première portion et ladite deuxième portion étant reliées par une première arête arrondie (14) ; ladite deuxième portion et ladite troisième portion étant reliées par une deuxième arête arrondie (16).

3. Support selon la revendication 1 ou 2, **caractérisé en ce que** ledit logement (9) du bloc, qui est approprié pour recevoir le coulisseau (5), comprend une première fente ouverte (27) qui se termine dans une deuxième fente ouverte (29), laquelle est plus large que la première fente et est appropriée pour recevoir un insert central (31) du coulisseau (5) ; ledit logement ayant une première fente angulaire fermée (33) qui est appropriée pour coopérer avec la deuxième arête arrondie (16) du coulisseau, dans la position ouverte, et une deuxième fente fermée (35) qui est appropriée pour coopérer avec la deuxième arête arrondie (16) du coulisseau dans la position fermée ; ledit logement comprenant une troisième fente (37) qui est appropriée pour coopérer avec la languette (19) du coulisseau dans la position fermée.

4. Support selon une ou plusieurs des revendications précédentes, **caractérisé en ce que** ledit coulisseau (5) possède un moyen de montage et de prise qui est constitué par un trou (23) qui est disposé entre les inserts (25) qui sont dirigés vers le support auquel le dispositif électrique sera fixé ; ledit trou étant approprié pour recevoir un outil pour l'actionnement dudit coulisseau ou un tourne-vis ou analogue afin de fixer ledit dispositif audit support.
